# EUROPEAN PATENT APPLICATION

(11) **EP 3 836 319 A1**
(43) Date of publication of application: **16.06.2021**
(21) Application number: 19846648.4
(22) Date of filing: 12.03.2019
(51) Int. Cl.: H01S 5/022, G01S 7/484, H01S 5/042

(54) **LASER DIODE ARRAY DEVICE MANUFACTURING METHOD, LASER LIGHT EMITTING CIRCUIT, AND RANGING DEVICE**

(30) Priority: 10.08.2018 JP 2018151826
(71) Applicant: OMRON Corporation, Shiokoji-dori, Shimogyo-ku, Kyoto-shi Kyoto 600-8530 (JP)
(72) Inventor: FUJIWARA, Naoki, Kyoto-shi, Kyoto 600-8530 (JP); KOGA, Hiroshi, Kyoto-shi, Kyoto 600-8530 (JP)
(74) Representative: HGF
(86) International application number: PCT/JP2019/010001
(87) International publication number: WO 2020/031414

(57) **Abstract**

Provided is a laser emitting circuit (4) that causes a LD array (1) including a plurality of LDs (1a, 1b, 1c) to simultaneously or sequentially emit pulsed laser light. The laser emitting circuit (4) includes the plurality of laser diodes of which anodes are electrically connected to one another, switching elements (41) that are electrically connected to cathodes of the respective laser diodes and control current flowing through each of the laser diodes, drive circuits (42) that control the switching elements, and a series circuit in which a capacitor and a resistor are electrically connected in series. The series circuit has one end electrically connected to a common anode of the plurality of laser diodes and another end grounded. The laser emitting circuit further includes a laser diode power supply input terminal (51) that is electrically connected to the common anode of the plurality of laser diodes and is for supplying electric charge to the capacitor, a drive circuit power supply input terminal for supplying power to the drive circuits, and pulse signal input terminals (52a, 552b, 52c) that are electrically connected to the respective drive circuits and input a pulse signal.

## Description

### TECHNICAL FIELD

The present disclosure relates to a method for manufacturing a laser diode array device, and a laser emitting circuit and a distance measuring device.

### BACKGROUND ART

A distance measuring means for measuring a distance to a target object by irradiating the target object with pulsed laser light and observing reflected light reflected by the target object is known. A laser diode (LD) is often used as a light source to emit pulsed laser light. Further, an LD array including a plurality of LDs is used as a light source in order to measure a distance over a wide range.

In a case where the target object moves relative to the distance measuring means, for example, in a case where the distance measuring means is attached to a moving object such as an automobile, it is desirable to increase the number of light pulse emissions per unit time for distance measurement to increase the number of distance measurement per unit time in order to avoid a collision between the moving object and the target object.

The distance measuring device irradiates a target object with pulsed light from an irradiation unit such as an LD, and receives reflected light from the target object with a light reception unit such as a photodiode. By measuring time taken from projection of pulsed light to reception of the pulsed light (time of flight), a distance from the distance measuring device to the target object is calculated based on light speed known in advance. By narrowing pulse width of projected pulsed light, width of a light reception signal is also narrowed. Thus, width of an error in measurement of light reception time is reduced, and distance measurement accuracy is improved.

A switching element that controls current flowing through an LD is used to have the LD to emit pulsed laser light. As the switching element, for example, a field-effect transistor (FET) is used (refer to Patent Document 1, for example).

### PRIOR ART DOCUMENT

### PATENT DOCUMENT

Patent Document 1: JP 2006-66654 A

### SUMMARY OF THE INVENTION

### PROBLEMS TO BE SOLVED BY THE INVENTION

In particular, in a case where high-speed operation is required, an N-channel enhancement FET is used as a switching element. As methods for connecting an N-channel FET, there are a method in which source is not grounded and a method in which source is grounded and electric potential is fixed.

A conventional multi-laser diode has a monolithic common cathode configuration. Therefore, in order to drive an individual laser diode, it has been required to provide a drive current control circuit on an anode side of the laser diode. That is, it has been necessary to have a configuration in which a common cathode of the multi-laser diode is grounded and source of an N-channel FET is connected to each anode. In this case, the source of the N-channel FET is not grounded.

It is gate-source voltage (Vgs) that controls switching operation of the N-channel FET, and it is desirable that Vgs is effectively applied by source of a FET being grounded. When source electric potential fluctuates with respect to gate drive electric potential of the FET, it becomes difficult to effectively apply Vgs, and speed of switching operation of the FET decreases.

If a source electrode of the FET can be grounded, switching speed can be increased. Therefore, in order to increase the switching speed and emit laser light having a narrow pulse width, it is preferable to adopt a configuration in which the source of the FET is grounded.

The present inventor focused on the fact that it is not possible to adopt a configuration in which individual FETs are connected to a cathode side of individual LDs in a monolithic common cathode configuration, while an LD array package for distance measurement normally has a monolithic common cathode configuration in which cathodes of respective LDs are electrically connected to one another. Further, it is very costly and time consuming to newly provide a semiconductor manufacturing line to manufacture an LD array having a monolithic common anode configuration that can adopt a configuration in which individual FETs are connected to a cathode side of individual LDs. Further, a great deal of techniques, equipment, and costs are required to accurately align optical axes of a plurality of non-monolithic LDs and fix the LDs as an LD array.

In one aspect, the present disclosure has been made in view of such circumstances, and an object of the present disclosure is to provide an LD array capable of facilitating optical axis alignment and narrowing width of a light projecting pulse.

### MEANS FOR SOLVING THE PROBLEMS

A first aspect of the present disclosure provides a method for manufacturing a laser diode array device including the steps of preparing a laser diode array including a plurality of laser diodes monolithically formed on a semiconductor substrate that is a cathode, electrically connecting a common conductive lead frame or conductive substrate on an end of each of anode sides of the plurality of laser diodes and fixing the plurality of laser diodes so that the conductive lead frame or the conductive substrate supports the plurality of laser diodes, and electrically separating cathodes of adjacent laser diodes from one another for each of the laser diodes.

With the above-described method, it is possible to manufacture, without shifting an optical axis, a laser diode array having a common anode configuration from a laser diode array having a monolithic common cathode configuration in which optical axes are accurately aligned.

A second aspect of the present disclosure provides a laser emitting circuit that simultaneously or sequentially emits pulsed laser light to a laser diode array including a plurality of laser diodes. The laser emitting circuit includes the plurality of laser diodes of which anodes are electrically connected to one another, switching elements that are electrically connected to cathodes of the respective laser diodes and control current flowing through each of the laser diodes, drive circuits that control the switching elements, and a series circuit in which a capacitor and a resistor are electrically connected in series. The series circuit has one end electrically connected to a common anode of the plurality of laser diodes and another end grounded. The laser emitting circuit further includes a laser diode power supply input terminal that is electrically connected to the common anode of the plurality of laser diodes and is for supplying electric charge to the capacitor, a drive circuit power supply input terminal for supplying power to the drive circuits, and pulse signal input terminals that are electrically connected to the respective drive circuits and input a pulse signal.

With the above-described configuration, a switching element can be disposed on a cathode side of the laser diodes, and switching speed can be increased. Therefore, it is possible to increase the switching speed and emit laser light having a narrow pulse width.

A third aspect of the present disclosure provides a laser emitting circuit that simultaneously or sequentially emits pulsed laser light to a laser diode array including a plurality of laser diodes. The laser emitting circuit includes the plurality of laser diodes of which anodes are electrically separated from one another, switching elements that are electrically connected to cathodes of the respective laser diodes and control current flowing through each of the laser diodes, drive circuits that control the switching elements, and a series circuit in which a capacitor and a resistor are electrically connected in series. The series circuit has one end electrically connected to an anode of the laser diodes and another end grounded. The laser emitting circuit further includes laser diode power supply input terminals that are electrically connected to anodes of the respective plurality of laser diodes and are for supplying electric charge to the capacitor, a drive circuit power supply input terminal for supplying power to the drive circuits, and pulse signal input terminals that are electrically connected to the respective drive circuits and input a pulse signal.

With the above configuration, anodes of the respective laser diodes are electrically separated, and even if one laser diode emits a light pulse, a capacitor connected to another laser diode is not discharged. Therefore, light projection operation of each of the LDs due to discharge of each of the capacitors is independent of light projection operation of another LD.

In the second aspect or third aspect of the present disclosure, the switching element may be a FET in which a drain electrode is electrically connected to a cathode of a laser diode and a source electrode is grounded, and the drive circuit may be a gate drive circuit electrically connected to a gate electrode of the FET.

With the above-described configuration, as compared with a case where the source electrode is not grounded, it is possible to easily increase an electric potential difference between electric potential of the source electrode and electric potential of the gate electrode and to increase switching speed of the FET.

In the second aspect or third aspect of the present disclosure, the FET may be a GaN-based FET.

Because a GaN-based FET has a wide band gap and high saturated electron velocity as compared with a silicon-based MOSFET, the GaN-based FET can perform high-speed switching operation. Therefore, with the above-described configuration, a laser emitting circuit capable of increasing switching speed and emitting laser light having a narrow pulse width is obtained.

A fourth aspect of the present disclosure provides a distance measuring device including a light projection unit that includes the laser emitting circuit according to the second aspect or third aspect of the present disclosure and that emits pulsed laser light, a light reception unit that receives laser light, and a detection unit that detects, based on time when the light projection unit emits laser light and time when the light reception unit receives the laser light, a distance the received laser light passes.

By including a laser emitting circuit having an increased switching speed, it is possible to emit laser light having a narrow pulse width and to obtain a distance measuring device with high accuracy in distance measurement.

In the fourth aspect of the present disclosure, the plurality of laser diodes of the laser emitting circuit may be aligned at equal intervals.

With the above-described configuration, the laser diodes are regularly aligned. Therefore, it is possible to obtain a distance measuring device that facilitates distance detection by the detection unit, control of the light projection unit by a control unit, or the like, and to perform highly accurate distance measurement.

### EFFECTS OF THE INVENTION

With a method for manufacturing a laser diode array device, and a laser emitting circuit and a distance measuring device according to the present disclosure, it is possible to narrow width of a light projecting pulse.

### BRIEF DESCRIPTION OF THE DRAWINGS

Fig. 1 is a diagram illustrating an application example of an LD array according to the present disclosure.
Fig. 2 is a side view illustrating a structural example of the LD array according to a first embodiment.
Fig. 3A is a diagram for describing an example of a method for manufacturing the LD array according to the first embodiment.
Fig. 3B is a diagram for describing an example of a method for manufacturing the LD array according to the first embodiment.
Fig. 3C is a diagram for describing an example of a method for manufacturing the LD array according to the first embodiment.
Fig. 3D is a diagram for describing an example of a method for manufacturing the LD array according to the first embodiment.
Fig. 4 is a diagram illustrating a configuration example of a laser emitting circuit according to the first embodiment.
Fig. 5 is a side view illustrating a structural example of the LD array according to a second embodiment.
Fig. 6 is a diagram illustrating a configuration example of a laser emitting circuit according to the second embodiment.

### MODES FOR CARRYING OUT THE INVENTION

Hereinafter, embodiments of a distance measuring device according to the present disclosure will be described with reference to the drawings as appropriate. In each of the following embodiments, similar components are denoted by the same reference characters.

### §1 Application example

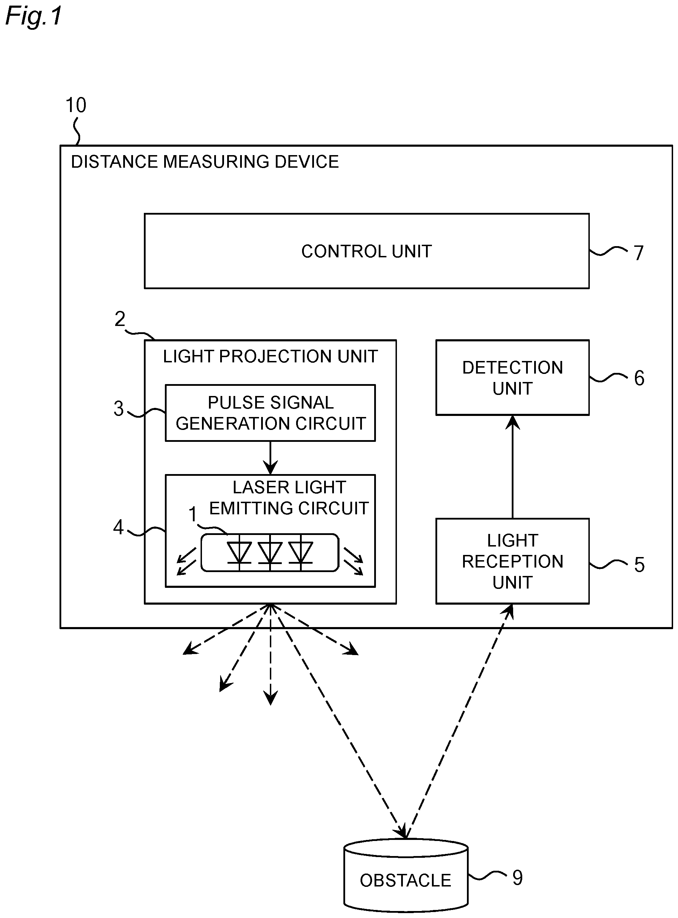

First, an example of a situation in which a laser diode (LD) array 1 according to the present disclosure is applied will be described with reference to Fig. 1. The LD array 1 can be applied to a distance measuring device 10 such as, for example, a LiDAR (LiDAR) for in-vehicle use. The distance measuring device 10 includes a light projection unit 2 that projects laser light to outside, a light reception unit 5, a detection unit 6, and a control unit 7.

The light projection unit 2 includes a pulse signal generation circuit 3 and a laser emitting circuit 4. The pulse signal generation circuit 3 is a circuit that generates a pulse signal at a timing instructed by the control unit 7 and outputs the pulse signal to the laser emitting circuit 4. The laser emitting circuit 4 is a circuit that simultaneously or sequentially emits light of an LD included in the LD array 1 based on an input pulse signal. In Fig. 1, laser light projected by the laser emitting circuit 4 is illustrated by a broken line.

The light reception unit 5 includes, for example, a photodiode, receives laser light reflected by an obstacle 9 such as a human, animal, road, or building outside, and generates a light reception signal. The detection unit 6 detects time of flight (Time of Flight, ToF) of laser light based on time when the light projection unit 2 projects laser light and time when the light reception unit 5 receives the laser light. Thus, it is possible to detect a flight distance of the laser light and to detect a distance between the distance measuring device 10 and the obstacle 9. The control unit 7 is a controller that controls entire operation of the distance measuring device 10. The control unit 7 includes a general-purpose processor such as a CPU or MPU that achieves a predetermined function by executing a program.

### §2 First embodiment

### <2.1 Structural example>

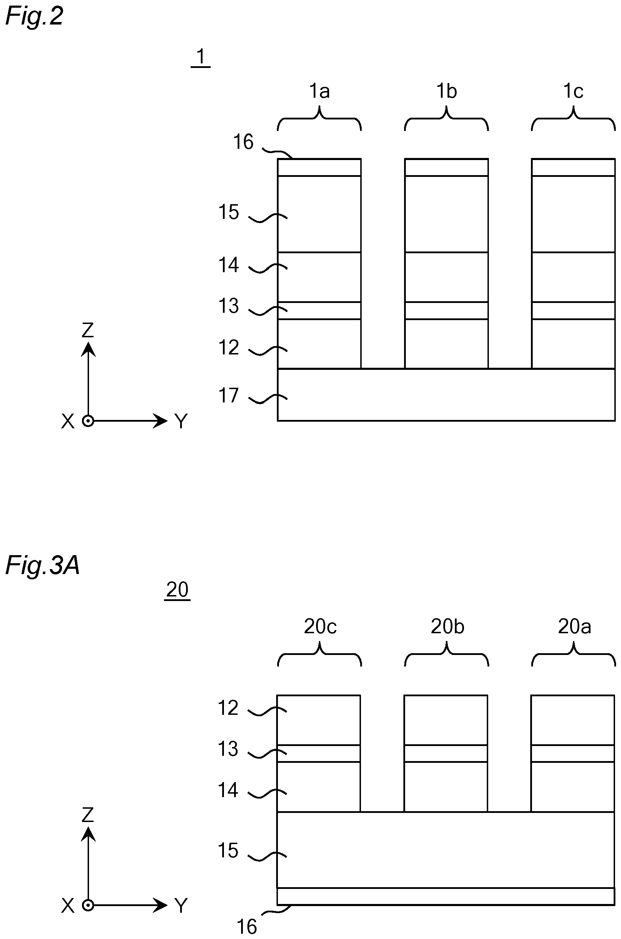

Fig. 2 is a side view illustrating a structural example of an LD array 1 according to a first embodiment. In an example in Fig. 2, the LD array 1 is an LD array having a three-channel configuration including three LDs 1a, 1b, and 1c arranged in a row at intervals from one another. Each of the LDs 1a, 1b, and 1c includes a p-type clad layer 12, an active layer 13 formed on the p-type clad layer 12, an n-type clad layer 14 formed on the active layer 13, an n-type semiconductor layer 15 formed on the n-type clad layer 14, and a cathode electrode 16 formed on the n-type semiconductor layer 15. A single anode electrode 17 is electrically connected (hereinafter, simply referred to as "connected") to a back surface of the p-type clad layer 12 of each of the LDs 1a, 1b, and 1c. That is, the LDs 1a, 1b, and 1c share the anode electrode 17. As described above, the LD array 1 has a common anode configuration.

For convenience of description, Fig. 2 provides an X-axis, a Y-axis, and a Z-axis that are orthogonal to one another. It is assumed that a stacking direction of the LD array 1 is a Z direction, and the LDs 1a, 1b, and 1c are arranged in a row in a Y-axis direction.

The LDs 1a, 1b, and 1c are known LDs. For example, the p-type clad layer 12 is a p-type AlGaAs layer, the active layer 13 is a GaAs layer or an AlGaAs layer, the n-type clad layer 14 is an n-type AlGaAs layer, and the n-type semiconductor layer 15 is an n-type GaAs layer. The cathode electrode 16 and the anode electrode 17 include, for example, Au, Cu, Al, Fe, an alloy including Au, Cu, Al, or Fe, or the like.

The LDs 1a, 1b, and 1c exemplified in Fig. 2 can emit laser light that is facing in the same direction, has an optical axis parallel to one another, and is arranged in a row at equal intervals.

### <2.2 Example of manufacturing method>

### [Step S101]

An example of a method for manufacturing the LD array 1 will be described with reference to Figs. 3A to 3D. First, as illustrated in Fig. 3A, an LD array 20 having a common cathode configuration including three LDs 20a, 20b, and 20c monolithically formed on an n-type semiconductor layer 15 as a substrate is prepared (S101) . Specifically, an n-type clad layer 14, an active layer 13, and a p-type clad layer 12 are formed in order on the n-type semiconductor layer 15 of the LD array 20. Moreover, a single cathode electrode 16 is formed on a back surface of the n-type semiconductor layer 15.

### [Step S102]

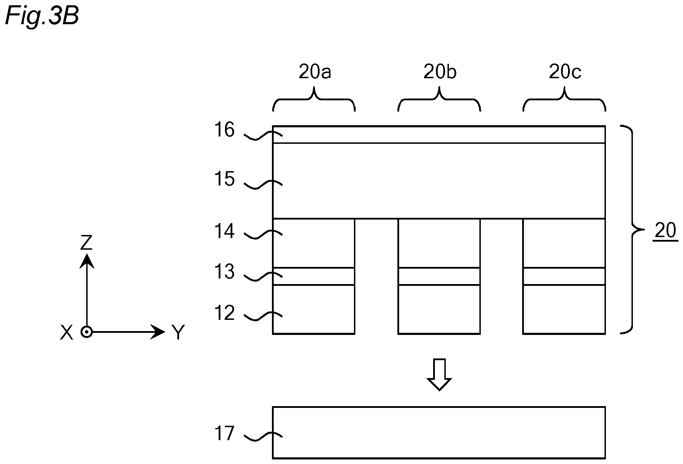

Next, as illustrated in Fig. 3B, the LD array 20 having a common cathode configuration is bonded to an anode electrode 17 so that the p-type clad layer 12 is connected to the anode electrode 17 (S102). The bonding is performed by using silver paste, solder, or the like. it should be noted that, in Fig. 3B, the LD array 20 is illustrated upside down as compared with Fig. 3A. That is, the LD array 20 in Fig. 3B is the LD array 20 in Fig. 3A rotated 180 ° around the X-axis.

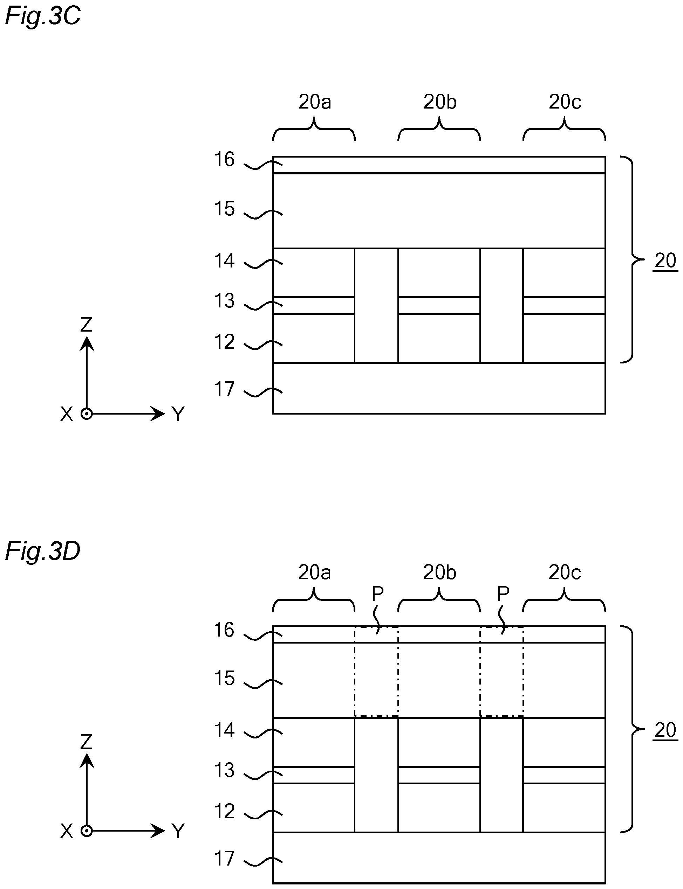

Fig. 3C is a diagram illustrating the LD array 20 having a common cathode configuration and the anode electrode 17 connected in step S102.

The anode electrode 17 illustrated in Figs. 3B and 3C is, for example, a metal lead frame used for an LD package on which a completed LD array 1 is mounted. The anode electrode 17 supports the completed LD array 1 and connects the p-type clad layer 12 and external wiring.

### [Step S103]

Next, cathodes of three adjacent LDs are electrically separated from one another (S103). For example, as illustrated in Fig. 3D, regions P of the n-type semiconductor layer 15 and cathode electrode 16, which are between the LDs, are removed or cut. The regions P are removed or cut, for example by being irradiated with a laser. Further, the regions P may be cut by a dicer. By removing or cutting the regions P, an LD array 1 having a common anode configuration as illustrated in Fig. 2 is completed.

By steps S101 to S103, an LD array 1 having a common anode configuration in which optical axes are accurately aligned can be obtained. Moreover, for example, by preparing a ready-made LD array 20 having a common cathode configuration in which optical axes are accurately aligned, an LD array 1 having a common anode configuration in which optical axes are accurately aligned can be obtained without newly providing a costly semiconductor manufacturing line.

### <2.3 Example of circuit configuration>

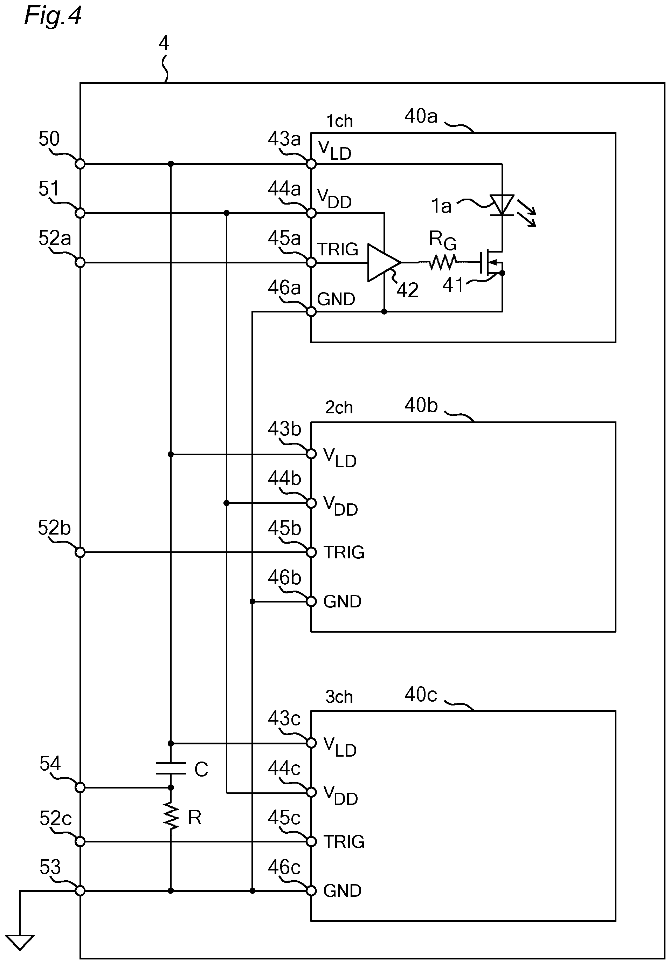

Fig. 4 is a diagram illustrating a configuration example of a laser emitting circuit 4 that emits a pulse laser by using an LD array 1. The laser emitting circuit 4 includes an LD array 1 having a three-channel configuration as described above. In Fig. 4, in order to organize a circuit structure, three LD channels of the LD array 1, which correspond to the LDs 1a, 1b, and 1c illustrated in Fig. 2, are illustrated separately.

The laser emitting circuit 4 includes three circuit units 40a, 40b and 40c, which correspond to three channels of the LD array 1. The circuit units 40a, 40b and 40c have the same structure. In Fig. 4, description of an internal structure of the circuit units 40b and 40c is omitted.

### <2.3.1 Example of circuit unit configuration>

The circuit unit 40a includes the LD 1a, a field-effect transistor (FET) 41, and a gate driver 42 that controls the FET 41. Further, the circuit unit 40a includes an LD power supply (VLD) terminal 43a connected to an anode of the LD 1a. Moreover, the circuit unit 40a includes a driver power supply (VDD) terminal 44a, a gate drive signal (TRIG) terminal 45a, and a ground (GND) terminal 46a, which are connected to the gate driver 42.

The VLD terminal 43a is connected to the anode of the LD 1a. Power is supplied to the gate driver 42 from an unillustrated external driver power supply via the VDD terminal 44a. For example, a pulse signal generated in an external pulse signal generation circuit 3 as illustrated in Fig. 1 is input to the TRIG terminal 45a. The GND terminal 46a is grounded.

The gate driver 42 is a drive circuit that performs switching of the FET 41 based on an input signal from the TRIG terminal 45a. An output terminal of the gate driver 42 is connected to a gate electrode of the FET 41. A gate resistor R_{G} may be inserted between the output terminal of the gate driver 42 and the gate electrode of the FET 41. A resistance value of the gate resistor R_{G} is selected so that ringing does not occur in voltage at a switch node of the FET 41, for example, in voltage at a cathode of the LD 1a, during switching of the FET 41 for example, and that switching speed of the FET 41 is a desired speed.

The FET 41 is, for example, a gallium nitride (GaN) -based FET. The FET 41 may be a silicon-based MOSFET. A source electrode of the FET 41 is connected to the GND terminal 46a and is grounded. A drain electrode of the FET 41 is connected to the cathode of the LD 1a. The anode of the LD 1a is connected to the VLD terminal 43a as described above. The FET 41 is an example of a "switching element" in the present disclosure.

### <2.3.2 Example of laser emitting circuit configuration>

The laser emitting circuit 4 includes the circuit units 40a, 40b and 40c. The VLD terminal 43a of the circuit unit 40a, a VLD terminal 43b of the circuit unit 40b, and a VLD terminal 43c of the circuit unit 40c are connected to a common LD power supply terminal 50. As described above, the laser emitting circuit 4 adopts a common anode configuration for the LD array 1.

One electrode of a capacitor C is also connected to the common LD power supply terminal 50. Another electrode of the capacitor C is connected to a ground terminal 53 via a resistor R. A current measurement terminal 54 is connected to a connection line between the capacitor C and the resistor R.

The VDD terminal 44a of the circuit unit 40a, a VDD terminal 44b of the circuit unit 40b, and a VDD terminal 44c of the circuit unit 40c are connected to a common driver power supply terminal 51.

The TRIG terminal 45a of the circuit unit 40a is connected to a first light emission signal input terminal 52a, a TRIG terminal 45b of the circuit unit 40b is connected to a second light emission signal input terminal 52b, and a TRIG terminal 45c of the circuit unit 40c is connected to a third light emission signal input terminal 52c.

The GND terminal 46a of the circuit unit 40a, a GND terminal 46b of the circuit unit 40b, and a GND terminal 46c of the circuit unit 40c are connected to a common ground terminal 53.

### <2.4 Example of circuit operation>

To the common LD power supply terminal 50 of the laser emitting circuit 4, an unillustrated LD power supply is connected and power is supplied. To the common driver power supply terminal 51, an unillustrated driver power supply is connected and voltage is applied. The ground terminal 53 is grounded, for example, as illustrated in Fig. 4.

For example, a pulse signal generated in an external pulse signal generation circuit 3 as illustrated in Fig. 1 is input to each of the light emission signal input terminals 52a, 52b, and 52c. A pulse signal input to the first light emission signal input terminal 52a is input to the gate driver 42 via the TRIG terminal 45a of the circuit unit 40a. The gate driver 42 amplifies the input pulse signal and outputs the signal to the gate electrode of the FET 41.

By the amplified pulse signal being applied to the gate electrode, an electric potential difference between electric potential of the source electrode and electric potential of the gate electrode, which is Vgs, exceeds unique threshold voltage of the FET 41, the FET 41 is turned "on", and drain current of the FET 41 flows. Thus, current flows through the LD 1a, and the LD 1a emits laser light. In this way, the FET 41 is switched based on the pulse signal and controls the current flowing through the LD 1a.

Then, when the FET 41 is turned on, electric charge stored in the capacitor C flows through the LD 1a to the GND terminal 46a. As described above, by providing the capacitor C in this way, current can be rapidly passed through the LD 1a when the FET 41 is turned on, and laser light having a narrow pulse width can be generated.

The FET 41 is repeatedly turned on and off according to the pulse signal input from the TRIG terminal 45a. At the same time, discharge and charge of the capacitor C are repeated.

Current flowing through the LD 1a is observed at the current measurement terminal 54. Observation of the current is performed by, for example, a control unit 7 as illustrated in Fig. 1. For example, the control unit 7 controls a pulse signal generation circuit 3, an unillustrated external LD power supply or external driver power supply, or the like, so that the current flowing through the LD 1a does not become excessive.

Operation of the circuit unit 40a has been mainly described. However, a similar applies to operation of the circuit units 40b and 40c. At this time, each time a trigger signal is input to any one of the light emission signal input terminals 52a, 52b, and 52c, the capacitor C connected to a common anode is discharged. When the trigger signal is disabled, the discharge from the capacitor C is stopped and charging is performed again.

As described above, in Fig. 4, the drain electrode of the FET 41 is connected to the cathode of the LD 1a, and the source electrode of the FET 41 is grounded. Unlike this configuration, a configuration in which a FET is connected to an anode side of the LD 1a is also conceivable. In a light projection circuit configuration using a conventional common cathode LD, a drain electrode of a FET is connected to a VLD terminal 43a, the source electrode of the FET is connected to an anode of an LD 1a, and a cathode of the LD 1a is connected to a GND terminal 46a to be grounded.

However, in the configuration in which a FET is connected to an anode side of the LD 1a, the source electrode of the FET is not grounded. Therefore, an electric potential difference between electric potential of the source electrode and electric potential of the gate electrode, which is VGS, is small. Therefore, switching speed of the FET is slow. In order to solve this, it is necessary to raise voltage of a signal output from the gate driver 42. However, raising the voltage is difficult and results in a large power consumption even though the raising the voltage is realized.

Therefore, in order to increase the switching speed of the FET 41 and emit laser light having a narrow pulse width, a configuration illustrated in Fig. 4 is advantageous in which the drain electrode of the FET 41 is connected to the cathode of the LD 1a, and the source electrode of the FET 41 is grounded. The LD array 1 having a common anode configuration is advantageous in that such a configuration can be adopted.

### <2.5 Example of light emission method>

Returning to Fig. 2, an example of a method for emitting the LDs 1a, 1b, and 1c of the LD array 1 will be described. For example, the LDs 1a, 1b, and 1c of the LD array 1 are used in a simultaneous light emission mode in which light pulses are emitted at the same timing. In a case of the simultaneous light emission mode, pulse signals in which pulses are generated at the same timing are input to the light emission signal input terminals 52a, 52b, and 52c illustrated in Fig. 4. In the simultaneous light emission mode, strong laser light can be emitted in an optical axis direction from a center of the LD array 1 by increasing electric charge charged in the capacitor C. Therefore, long distance measurement can be performed.

Next, another example of a method for emitting the LDs 1a, 1b, and 1c of the LD array 1 will be described. For example, the LDs 1a, 1b, and 1c of the LD array 1 are used in a sequential light emission mode in which light pulses are emitted one by one in order. In a case of the sequential light emission mode, pulse signals in which pulses are generated at different timings are input to the light emission signal input terminals 52a, 52b, and 52c illustrated in Fig. 4. The sequential light emission mode is utilized, for example, in a LiDAR device that sequentially generates distance images at a desired frame rate (for example, 30 fps). In the sequential light emission mode, for example, the LDs 1a, 1b, and 1c are caused to emit light pulses one by one in order as described above, and the LD array is rotated around the Y-axis in Fig. 2. Thus, a surrounding of the LD array 1 is scanned by pulsed laser light. Thus, distances to obstacles in various directions can be measured.

### <2.6 Functions and effects>

As described above, the LD array 1 according to the first embodiment is manufactured by a method including a step of preparing the LD array 20 including three LDs monolithically formed on an n-type semiconductor substrate 15 that is a cathode (S101), a step of electrically connecting a common lead frame 17 on an end of each of anode sides of the LDs and fixing the three LDs so that the lead frame 17 supports the LDs (S102), and a step of electrically separating cathodes of adjacent LDs from one another for each of the LDs (S103).

According to this manufacturing method, if an LD array 20 having a common cathode configuration in which optical axes are accurately aligned is prepared in step S101, an LD array 1 having a common anode configuration in which optical axes are accurately aligned can be obtained by transferring each of the LDs on the lead frame 17 with the optical axes aligned. For example, by preparing a monolithically formed LD array 20 in which LDs are facing in the same direction, have optical axes parallel to one another, and are arranged in a row at equal intervals, it is possible to obtain an LD array 1 having a common anode configuration in which the LDs are facing in the same direction and have optical axes parallel to one another. Therefore, for example, by preparing a ready-made LD array 20 having a common cathode configuration, an LD array 1 having a common anode configuration in which optical axes are accurately aligned can be obtained without newly providing a costly semiconductor manufacturing line.

Further, the first embodiment discloses the laser emitting circuit 4 that causes the LD array 1 including the three LDs 1a, 1b, and 1c to simultaneously or sequentially emit pulsed laser light. The laser emitting circuit 4 includes the three LDs 1a, 1b, and 1c of which anodes are electrically connected to one another, a FET 41 that is electrically connected to a cathode of each of the LDs 1a, 1b, and 1c and controls current that flows through each of the LDs 1a, 1b, and 1c, a gate driver 42 that controls the FET 41, and a series circuit in which the capacitor C and the resistor R are electrically connected in series. The series circuit has one end electrically connected to a common anode of the LDs 1a, 1b, and 1c and has another end grounded.

The laser emitting circuit 4 includes the LD power supply terminal 50 that is electrically connected to the common anode of the LDs 1a, 1b, and 1c and is for supplying electric charge to the capacitor C, the driver power supply terminal 51 for supplying power to a gate driver 42, and the light emission signal input terminals 52a, 52b, and 52c that are electrically connected to the respective gate drivers 42 and input a pulse signal.

According to the LD array 1 having a common anode configuration according to the first embodiment, a drain electrode of a FET can be connected to a cathode of each of the LDs 1a, 1b, and 1c, and a source electrode of a FET can be grounded. Thus, it is possible to increase switching speed of the FETs and emit laser light having a narrow pulse width.

The FETs may be GaN-based FETs.

Because a GaN-based FET has a wide band gap and high saturated electron velocity as compared with a silicon-based MOSFET, the GaN-based FET can perform high-speed switching operation. Therefore, by adopting a GaN-based FET as the FET, it is possible to emit laser light having a narrower pulse width.

### §3 Second embodiment

### <3.1 Structural example>

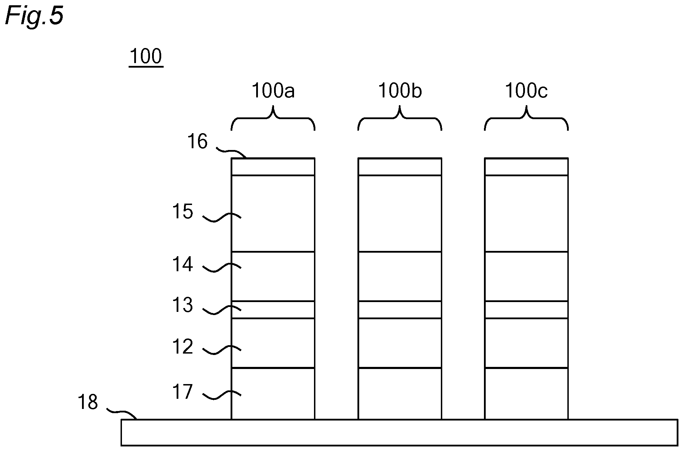

Fig. 5 is a side view illustrating a structural example of an LD array 100 according to a second embodiment. The LD array 100 is mounted on a support base 18. In an example in Fig. 5, the LD array 100 is an LD array having a three-channel configuration including three LDs 100a, 100b, and 100c arranged in a row at intervals from one another. Anode electrodes 17 of the LDs 100a, 100b, and 100c are separated from one another. As described above, the LD array 100 according to the second embodiment is not an LD array having a common anode configuration.

By the LDs 100a, 100b, and 100c, the LD array 100 is aligned so as to emit laser light that is facing in the same direction, has optical axes parallel to one another, and is arranged in a row at equal intervals.

### <3.2 Example of manufacturing method>

Next, an example of a method for manufacturing the LD array 100 will be described The three separated LDs are aligned so that the LDs emit laser light that is facing in the same direction, has optical axes parallel to one another, and is arranged in a row at equal intervals, and then the LDs are fixed to separate leads. Fixing is performed by using silver paste, solder, or the like.

### <3.3 Example of circuit configuration>

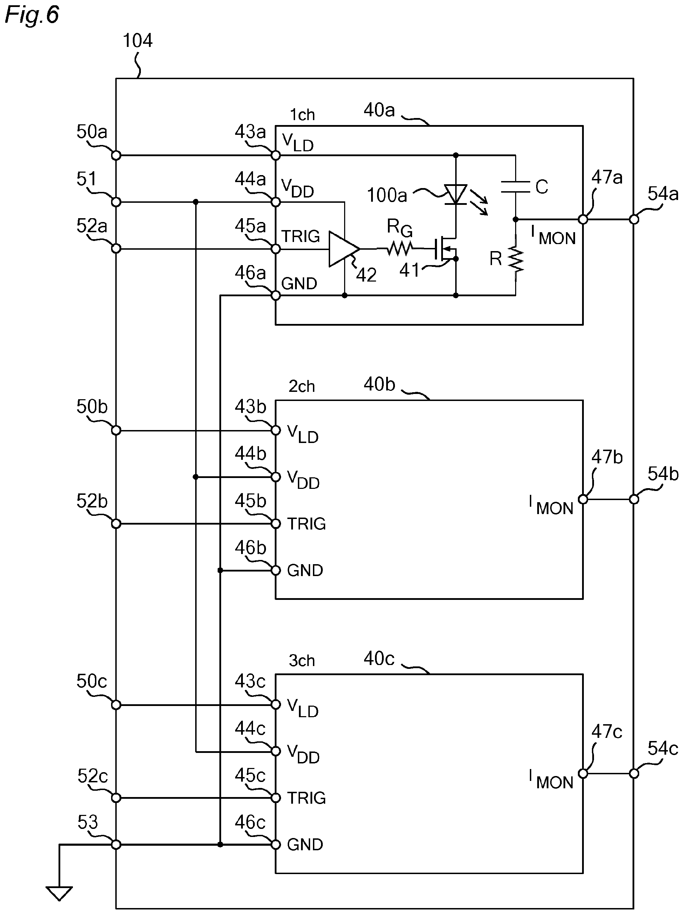

Fig. 6 is a diagram illustrating a configuration example of a laser emitting circuit 104 that emits a pulse laser by using the LD array 100. In the LD array 100, because respective terminals of the laser diodes are separated from one another, a circuit configuration of the laser emitting circuit 104 is different from the circuit configuration of the laser emitting circuit according to the first embodiment. Specifically, a VLD terminal 43a of a circuit unit 40a is connected to a first LD power supply terminal 50a, a VLD terminal 43b of a circuit unit 40b is connected to a second LD power supply terminal 50b, and a VLD terminal 43c of a circuit unit 40c is connected to a third LD power supply terminal 50c. Separate LD power supplies are connected to the respective LD power supply terminals 50a, 50b, and 50c.

Compared with a circuit having a common anode configuration in which the VLD terminal 43a, the VLD terminal 43b, and the VLD terminal 43c are connected to one another, in the laser emitting circuit 104 according to the present embodiment, the circuit units 40a, 40b and 40c do not share a common capacitor. That is, in the present embodiment, as illustrated in Fig. 6, the circuit unit 40a further includes a capacitor C and a resistor R. One electrode of the capacitor C is also connected to the VLD terminal 43a. Another electrode of the capacitor C is connected to a GND terminal 46a via the resistor R. A current monitor (IMON) terminal 47a is connected to a connection line between the capacitor C and the resistor R. Configurations of the circuit units 40b and 40c are similar to the configuration of the circuit unit 40a.

In the laser emitting circuit 104, the IMON terminal 47a of the circuit unit 40a is connected to a first current measurement terminal 54a, an IMON terminal 47b of the circuit unit 40b is connected to a second current measurement terminal 54b, and an IMON terminal 47c of the circuit unit 40c is connected to a third current measurement terminal 54c.

One terminal of the capacitor C of the circuit unit 40a is connected to the first LD power supply terminal 50a via the VLD terminal 43a, one terminal of an unillustrated capacitor of the circuit unit 40b is connected to the second LD power supply terminal 50b via the VLD terminal 43b, and one terminal of an unillustrated capacitor of the circuit unit 40c is connected to the third LD power supply terminal 50c via the VLD terminal 43c.

### <3.4 Functions and effects>

As described above, in the laser emitting circuit 104 that causes the LD array 100 according to the second embodiment to simultaneously or sequentially emit pulsed laser light, anodes of the respective LDs 100a, 100b, and 100c are electrically separated from one another.

The laser emitting circuit 104 includes LD power supply terminals 50a, 50b, and 50c that are electrically connected to the anodes of the respective LDs 100a, 100b, and 100c and are for supplying power to the LDs 100a, 100b, and 100c, the driver power supply terminal 51 for supplying power to gate drivers 42, and the light emission signal input terminals 52a, 52b, and 52c that are electrically connected to the respective gate drivers 42 and input a pulse signal.

In the laser emitting circuit 104 according to the second embodiment, because the anodes of the respective LDs 100a, 100b and 100c are electrically separated from one another, one capacitor can be provided for each of the LDs 100a, 100b, and 100c. Thus, each of LD channels operates independently. Therefore, light pulse emission operation and a period of charging a capacitor can be controlled independently for each of the LD channels.

More specific description will be described as compared with a case of a common anode configuration. In a case of the common anode configuration illustrated in Fig. 4 for example, after turning on the FET 41 of the circuit unit 40a and causing the LD 1a to emit a first light pulse, the common capacitor C connected to all the circuit units 40a, 40b and 40c is required to be charged before causing the LD of the next circuit unit 40b to emit light. Therefore, light pulse emission operation and a period of charging the capacitor cannot be controlled independently for each of the LD channels.

Meanwhile, in a case of the second embodiment in which the anodes of the LDs 100a, 100b, and 100c are electrically separated from one another, when the LD 100a is caused to emit a first light pulse, for example, the capacitor C of the circuit unit 40a is discharged, while the capacitors of the circuit unit 40b and circuit unit 40c are not discharged and remain charged. Therefore, light pulse emission operation and a period of charging a capacitor can be controlled independently for each of the LD channels.

### §4 Modifications

The embodiments of the present disclosure have been described in detail above. However, the above description is merely an example of the present invention, and various improvements and modifications can be made without departing from the scope of the present invention. For example, the following changes can be made. It should be noted that, in the following, similar reference characters will be used for components similar to the components in the above embodiments, and points similar to the points in the above embodiments are omitted as appropriate. The following modifications can be combined as appropriate.

### <4.1>

In the first and second embodiments, examples of the LD array 1 or 100 including three LDs have been described. However, the number of LDs included in the LD array 1 or 100 is not limited to three, and is only required to be plural.

### <4.2>

In the first and second embodiments, an example of a method for manufacturing the LD array 1 or 100 has been described. The method starts with a step of preparing an LD array 20 that has a common cathode configuration and includes three LDs monolithically formed on an n-type semiconductor substrate 15 that is a cathode (S101). However, a method for manufacturing the LD array 1 or 100 is not limited to this. For example, the LD array 1 may be formed by a step of preparing a p-type semiconductor substrate first, and stacking a p-type clad layer 12, an active layer 13, an n-type clad layer 14, and a cathode electrode 16 in order on a surface of the p-type semiconductor substrate, a step of forming an anode electrode 17 on a back surface of the p-type semiconductor substrate, and a step of removing an unnecessary portion between LDs by etching, or the like.

### §5 Disclosure

The present disclosure includes the following aspects.

A method for manufacturing a laser diode array device (1) including the steps of
preparing a laser diode array (20) including a plurality of laser diodes (20a, 20b, 20c) monolithically formed on a semiconductor substrate (15) that is a cathode (S101),
electrically connecting a common conductive lead frame or conductive substrate (17) on an end of each of anode sides of the plurality of laser diodes (20a, 20b, 20c) and fixing the plurality of laser diodes (20a, 20b, 20c) so that the conductive lead frame or the conductive substrate (17) supports the plurality of laser diodes (20a, 20b, 20c) (S102), and
electrically separating cathodes of adjacent the plurality of laser diodes (20a, 20b, 20c) from one another for each of the laser diodes (20a, 20b, 20c) (S103).

A laser emitting circuit (4) that causes a laser diode array (1) including a plurality of laser diodes (1a, 1b, 1c) to simultaneously or sequentially emit pulsed laser light, the laser emitting circuit (4) including
the plurality of laser diodes (1a, 1b, 1c) of which anodes are electrically connected to one another,
switching elements (41) that are electrically connected to cathodes of the respective laser diodes (1a, 1b, 1c) and control current flowing through each of the laser diodes (1a, 1b, 1c),
drive circuits (42) that control the switching elements (41),
a series circuit in which a capacitor (C) and a resistor (R) are electrically connected in series, wherein the series circuit has one end electrically connected to a common anode of the plurality of laser diodes (1a, 1b, 1c) and another end grounded,
a laser diode power supply input terminal (50) that is electrically connected to the common anode of the plurality of laser diodes (1a, 1b, 1c) and is for supplying electric charge to the capacitor (C),
a drive circuit power supply input terminal (51) for supplying power to the drive circuits (42), and
pulse signal input terminals (52a, 52b, 52c) that are electrically connected to the respective drive circuits (42) and input a pulse signal.

A laser emitting circuit (104) that causes a laser diode array (100) including a plurality of laser diodes (100a, 100b, 100c) to simultaneously or sequentially emit pulsed laser light, the laser emitting circuit (104) including
the plurality of laser diodes (100a, 100b, 100c) of which anodes are electrically separated from one another,
switching elements (41) that are electrically connected to cathodes of the respective laser diodes (100a, 100b, 100c) and control current flowing through each of the laser diodes (100a, 100b, 100c),
drive circuits (42) that control the switching elements (41),
a series circuit in which a capacitor (C) and a resistor (R) are electrically connected in series and that has one end electrically connected to an anode of the laser diodes (100a 100b, 100c) and another end grounded,
laser diode power supply input terminals (50a, 50b, 50c) that are electrically connected to anodes of the respective plurality of laser diodes (100a, 100b, 100c) and are for supplying electric charge to the capacitor (C),
a drive circuit power supply input terminal (51) for supplying power to the drive circuits (42), and
pulse signal input terminals (52a, 52b, 52c) that are electrically connected to the respective drive circuits (42) and input a pulse signal.

The laser emitting circuit (4, 104) according to claim 2 or 3, in which
the switching elements (41) are FETs in which a drain electrode is electrically connected to a cathode of the laser diodes (1a, 1b, 1c, 100a, 100b, 100c) and a source electrode is grounded, and
the drive circuits (42) are gate drive circuits electrically connected to a gate electrode of each of the FETs (41).

The laser emitting circuit (4) according to claim 4,
in which the FET (41) is a GaN-based FET.

A distance measuring device (10) including
a light projection unit (2) that includes the laser emitting circuit (4, 104) according to any one of claims 2 to 5 and that emits pulsed laser light,
a light reception unit (5) that receives laser light, and
a detection unit (6) that detects, based on time when the light projection unit (2) emits laser light and time when the light reception unit (5) receives the laser light, a distance the received laser light passes.

The distance measuring device (10) according to claim 6, in which the plurality of laser diodes of the laser emitting circuit (4) are aligned at equal intervals.

### DESCRIPTION OF REFERENCE CHARACTERS

1 LD array
1a, 1b, 1c LD
2 Light projection unit
3 Pulse signal generation circuit
4 Laser emitting circuit
5 Light reception unit
6 Detection unit
7 Control unit
10 Ranging device
12 P-type clad layer
13 Active layer
14 N-type clad layer
15 N-type semiconductor layer (n-type semiconductor substrate)
16 Cathode electrode
17 Anode electrode (lead frame)
20 Laser diode array
40a, 40b, 40c Circuit unit
41 FET
42 Gate driver (gate drive circuit)
43a, 43b, 43c VLD terminal
44a, 44b, 44c VDD terminal
45a, 45b, 45c TRIG terminal
46a, 46b, 46c GND terminal
47a, 47b, 47c IMON terminal
50, 50a, 50b, 50c LD power supply terminal
51 Driver power supply terminal
52a, 52b, 52c Light emission signal input terminal
53 Ground terminal
54, 54a, 54b, 54c Current measurement terminal

## Claims

1. A method for manufacturing a laser diode array device comprising:
preparing a laser diode array including a plurality of laser diodes monolithically formed on a semiconductor substrate that is a cathode;
electrically connecting a common conductive lead frame or conductive substrate on an end of each of anode sides of the plurality of laser diodes and fixing the plurality of laser diodes so that the conductive lead frame or the conductive substrate supports the plurality of laser diodes; and
electrically separating cathodes of adjacent the plurality of laser diodes from one another for each of the laser diodes.

2. A laser emitting circuit that causes a laser diode array including a plurality of laser diodes to simultaneously or sequentially emit pulsed laser light, the laser emitting circuit comprising:
the plurality of laser diodes of which anodes are electrically connected to one another;
switching elements that are electrically connected to cathodes of the respective laser diodes and control current flowing through each of the laser diodes;
drive circuits that control the switching elements;
a series circuit in which a capacitor and a resistor are electrically connected in series, wherein the series circuit has one end electrically connected to a common anode of the plurality of laser diodes and another end grounded;
a laser diode power supply input terminal that is electrically connected to the common anode of the plurality of laser diodes and is for supplying electric charge to the capacitor;
a drive circuit power supply input terminal for supplying power to the drive circuits; and
pulse signal input terminals that are electrically connected to the respective drive circuits and input a pulse signal.

3. A laser emitting circuit that causes a laser diode array including a plurality of laser diodes to simultaneously or sequentially emit pulsed laser light, the laser emitting circuit comprising:
the plurality of laser diodes of which anodes are electrically separated from one another;
switching elements that are electrically connected to cathodes of the respective laser diodes and control current flowing through each of the laser diodes;
drive circuits that control the switching elements;
a series circuit in which a capacitor and a resistor are electrically connected in series, wherein the series circuit has one end electrically connected to an anode of the laser diodes and another end grounded;
laser diode power supply input terminals that are electrically connected to anodes of the respective plurality of laser diodes and are for supplying electric charge to the capacitor;
a drive circuit power supply input terminal for supplying power to the drive circuits; and
pulse signal input terminals that are electrically connected to the respective drive circuits and input a pulse signal.

4. The laser emitting circuit according to claim 2 or 3, wherein
the switching elements are FETs in which a drain electrode is electrically connected to a cathode of the laser diodes and a source electrode is grounded, and
the drive circuits are gate drive circuits electrically connected to a gate electrode of each of the FETs.

5. The laser emitting circuit according to claim 4, wherein the FET is a GaN-based FET.

6. A distance measuring device comprising:
a light projection unit that includes the laser emitting circuit according to any one of claims 2 to 5 and that emits pulsed laser light;
a light reception unit that receives laser light; and
a detection unit that detects, based on time when the light projection unit emits laser light and time when the light reception unit receives the laser light, a distance the received laser light passes.

7. The distance measuring device according to claim 6, wherein the plurality of laser diodes of the laser emitting circuit are aligned at equal intervals.
